## Europäisches Patentamt
## European Patent Office
## Office européen des brevets

(11) Numéro de publication: **0 054 597 A1**

# DEMANDE DE BREVET EUROPEEN

(21) Numéro de dépôt: **80430031.7**

(22) Date de dépôt: **18.12.80**

(51) Int. Cl.³: **H 01 L 23/48,** H 01 L 23/40, H 01 L 23/36, H 01 R 13/533

(43) Date de publication de la demande: **30.06.82** Bulletin 82/26

(71) Demandeur: **International Business Machines Corporation, Armonk, N.Y. 10504 (US)**
(84) Etats contractants désignés: **DE GB**

(71) Demandeur: **Compagnie IBM FRANCE, 5 Place Vendôme, F-75000 Paris 1er (FR)**
(84) Etats contractants désignés: **FR**

(72) Inventeur: **Faida, André, Quartier Les Selves Plan de Carros, F-06510 Carros (FR)**
Inventeur: **Klein, Daniel Jacques Henri, Les Ondines 42 Route de France, F-06800 Cagnes/Mer (FR)**

(74) Mandataire: **Lattard, Nicole, COMPAGNIE IBM FRANCE Département de Propriété Industrielle, F-06610 La Gaude (FR)**

(84) Etats contractants désignés: **DE FR GB**

(54) **Dispositif pour le refroidissement des broches de modules.**

(57) Dispositif pour le refroidissement des modules de circuits intégrés, comprenant des manchons (4) qui sont placés autour des broches (3) du module à refroidir (1). Chaque manchon comporte un corps cylindrique creux qui reçoit une broche et des ailettes de diffusion de la chaleur. Ces manchons servent en même temps d'entretoise entre le module et la carte sur laquelle il est enfiché.

ACTORUM AG

EP 0 054 597 A1

# DISPOSITIF POUR LE REFROIDISSEMENT DES BROCHES DE MODULES

## Description de l'Invention

### Domaine Technique

La présente invention concerne un dispositif pour le refroidissement des modules à partir de ses broches et plus
particulièrement un manchon muni d'ailettes diffusant la
chaleur, monté sur les broches et pouvant servir avantageusement d'entretoise.

Les circuits composant une machine sont intégrés dans des
microplaquettes semi-conductrices elles-mêmes montées,
généralement par soudure sur un substrat céramique. Ce
substrat est muni d'un grand nombre de broches entrée/
sortie permettant d'amener les tensions d'alimentation
nécessaires au fonctionnement des circuits intégrés dans
les microplaquettes et de transporter les signaux entre les
microplaquettes et le panneau sur lesquels les modules sont
enfichés. Après encapsulation, le substrat muni de ses
microplaquettes et de ses broches, constitue un module
électronique. Etant donné les densités qui sont maintenant
atteintes grâce aux techniques d'intégration de plus en
plus poussées, un problème qui devient très critique est
celui de l'évacuation de la chaleur dissipée par les différents circuits constituant les microplaquettes.

### Art Antérieur

Il existe de nombreux moyens pour améliorer le refroidissement des modules. L'une des solutions consiste à
prévoir des radiateurs pour refroidir les capots des modules, comme décrit dans les articles parus dans l'IBM Technical Disclosure Bulletin, Vol. 14, No.1, juin 1971, page 182
et Vol. 22, No.3, août 1979, pages 902-903.

2 0054597

Une autre solution, telle que décrite dans l'article paru dans l'IBM Technical Disclosure Bulletin, Vol. 19, No.9, février 1977, page 3370, consiste à prévoir un capot métallique pour évacuer la chaleur du dos de la microplaquette. Les broches portées au potentiel de la masse sont connectées électriquement au capot par des connexions en soudure. Le radiateur est donc commun à ces seules broches et par conséquent, la dissipation de chaleur n'est pas satisfaisante.

La solution décrite dans le certificat d'utilité No. 77 31267, déposé en France le 18 Octobre 1977 et publié sous le numéro 2 368 868 consiste également à prévoir une plaque métallique servant de diffuseur de chaleur, dans laquelle sont insérées les broches portées à un même potentiel, ce qui limite aussi les possibilités de dissipation de chaleur, la réalisation du module et sa liaison à la carte de circuits imprimés.

De plus toutes ces solutions prennent de la place et limitent la densité des modules qui peuvent être enfichés sur une carte.

### Résumé de l'Invention

Un objet de la présente invention est de réaliser un dispositif de refroidissement des broches des modules qui améliore de façon sensible la dissipation de la chaleur et par là permet d'augmenter la densité d'intégration.

Un autre objet de la présente invention est de réaliser un dispositif de refroidissement qui soit simple, ne nécessite aucune transformation des lignes de fabrication et de montage des modules, et enfin qui n'augmente pas le volume des modules.

Encore un autre objet de la présente invention est de réaliser un dispositif qui permet de refroidir individuellement chaque broche d'un module.

Le dispositif de l'invention est utilisé pour refroidir les modules dans lesquels sont montés les microplaquettes de circuits intégrés. Ces modules comportent des broches d'entrée-sortie qui sont enfichées dans une carte de circuit imprimé. Ces broches sont traversées par des courants relativement importants, et ne participaient jusqu'alors en aucune façon à la dissipation thermique du module. Chaque broche reçoit individuellement un diffuseur de chaleur qui dans un mode de réalisation préféré aura la forme d'un manchon cylindrique réalisé dans un matériau bon conducteur de la chaleur. La surface intérieure du manchon s'adapte à la surface extérieure de la broche, et sa surface extérieure comporte des ailettes de refroidissement qui accroissent de manière sensible sa surface de telle sorte que la dissipation de chaleur est améliorée de façon très significative.

De plus ces manchons diffuseurs de chaleur peuvent avantageusement servir d'entretoises entre le module et la carte de circuits imprimés.

Conformément à une autre réalisation, les broches comportent sur leur partie supérieure des ailettes en forme d'anneaux régulièrement espacées, ailettes qui servent de radiateur et d'entretoise.

Conformément à encore une autre réalisation, le manchon affecte la forme d'une broche dont la partie supérieure présente intérieurement un évidement central destiné à recevoir la broche du module et la partie extérieure comporte lesdites ailettes.

D'autres objets, caractéristiques et avantages de la présente invention ressortiront mieux de l'exposé qui suit fait en référence aux dessins annexés à ce texte qui représentent un mode de réalisation préféré de celle-ci.

## Brève Description des Figures

La figure 1 représente un module avec des manchons conformément à la présente invention utilisés d'une part comme radiateur pour dissiper la chaleur et d'autre part comme entretoises pour faciliter l'écoulement de l'air entre le module et le circuit imprimé et donc la dissipation thermique.

La figure 2 représente en perspective un manchon.

La figure 3 représente vu en coupe un manchon comportant un nombre d'ailettes approprié pour le refroidissement des modules actuels.

La figure 4 représente vu en coupe un manchon adapté pour pouvoir être utilisé de façon efficace avec les broches de longueur standard.

La figure 5 représente deux courbes montrant les avantages de la présente invention.

## Description Détaillée de l'Invention

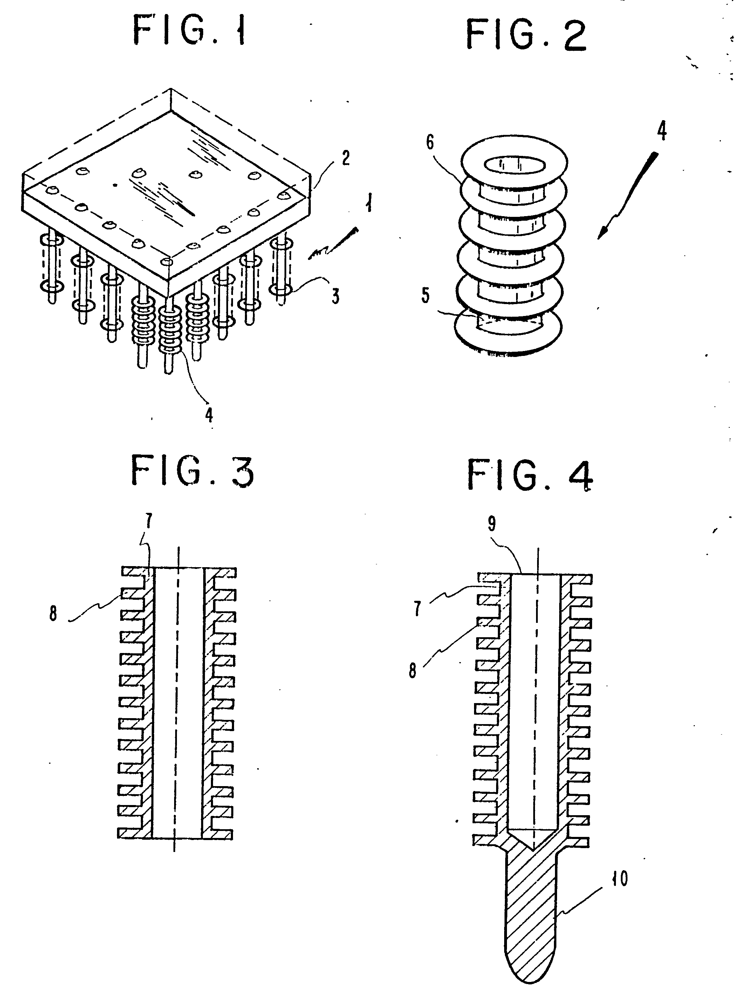

Sur la figure 1 est représenté un module 1 classique comportant un capot 2, recouvrant un substrat céramique sur lequel sont disposées différentes microplaquettes (non représentée). On accède électriquement aux circuits sur les microplaquettes par des broches d'entrée/sortie 3 qui dans cet exemple sont cylindriques. Sur la figure 1, un certain nombre de broches a été représenté à titre d'exemple, ce nombre n'étant bien entendu pas limitatif.

Conformément à la présente invention des manchons 4 sont montés sur les broches pour améliorer la dissipation de la chaleur.

Les manchons 4 sont représentés plus en détail sur la figure 2.

Ils comprennent un corps cylindrique 5, creux dans lequel la broche est placée. Des ailettes de refroidissement 6 permettent d'augmenter la surface de refroidissement. Dans un mode de réalisation préféré, ces ailettes ont la forme d'anneaux. Dans un autre mode de réalisation, elles peuvent prendre la forme d'une hélice. Les anneaux constituent avec le corps creux cylindrique un élément d'une seule pièce comme on peut le voir sur la vue en coupe de la figure 3.

Ces manchons sont rigides, ils sont réalisés dans la même matière que les broches, en cuivre étamé par exemple. De cette façon, ils améliorent la tenue mécanique des broches et servent en même temps de radiateurs et d'entretoises entre le module et la carte sur laquelle il est sera monté. Sur la figure 2, on n'a représenté que six ailettes 6 pour simplifier le dessin, étant entendu que ce nombre, de même que l'espacement entre les ailettes, leur forme et leur diamètre extérieur peuvent être adaptés en fonction des applications, suivant la quantité de chaleur à dissiper. Ces caractéristiques dépendent naturellement de la longueur des broches (limitée par la solidité et la rigidité normalement requises), et de la distance entre les broches.

Ces manchons étant cylindriques, leur manipulation par les outils automatiques sur les chaînes de montage des modules ne pose pas de problème et ils peuvent très facilement être montés en fin de procédé une fois le module achevé. Cette étape remplace l'étape de formation des butées sur les quatre broches disposées aux angles du module, destinées à assurer un espace minimal entre le module et la carte; cette étape n'étant plus nécessaire puisque les manchons de l'invention servent d'entretoises.

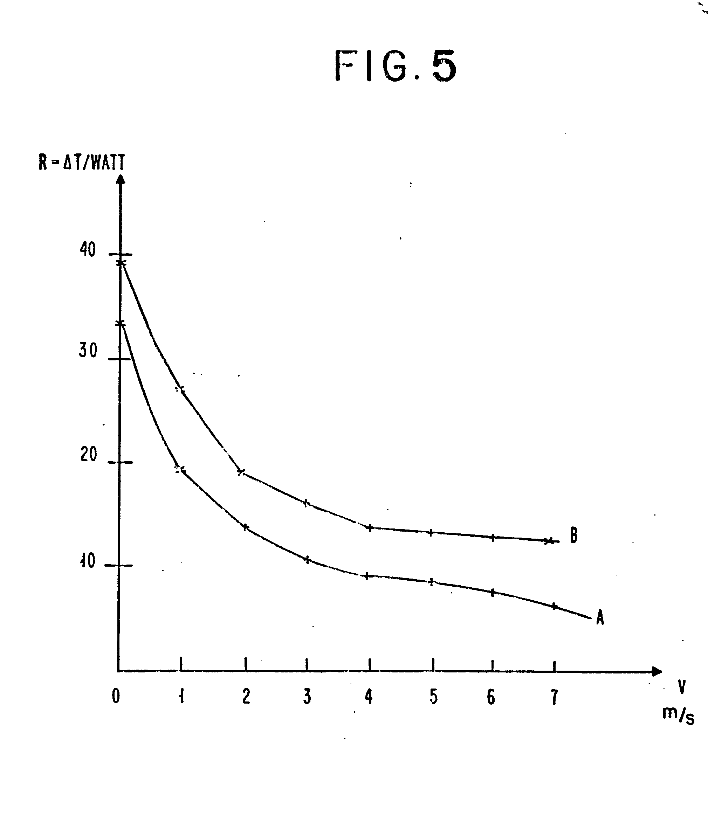

Sur la figure 3 est représenté en coupe un manchon typique qui correspond à une application déterminée et avec lequel les mesures représentées sur la figure 5 ont été faites.

Ce manchon 7 a la même forme que les manchons 4 des figures 1 et 2 mais comporte treize ailettes 8. Le diamètre intérieur du corps creux 9 est de 0,7 ± 0,05 mm, le diamètre extérieur est de 0,9 ± 0,01 mm. Le diamètre extérieur des ailettes est de 1,6 ± 0,1 mm et leur espacement est de 0,2 ± 0,02 mm. L'épaisseur des ailettes est de 0,11 ± 0,002 mm.

Avec un manchon présentant ces caractéristiques, la surface de refroidissement de chaque broche est de de 46,3 mm$^2$, ce qui est à peu près vingt fois plus qu'avec les techniques actuelles. Deux manchons se trouvent distants de 0,94 mm.

La hauteur du manchon, implique que les broches aient une longueur suffisante pour que le module étant enfiché dans une carte, elles dépassent suffisamment pour que les soudures des broches sur la carte soient suffisamment solides.

Sur la figure 4, on a représenté un manchon qui présente les caractéristiques, données ci-dessus, et qui a été adapté pour pouvoir recevoir une broche de longueur standard. La partie creuse à l'intérieur du manchon est limitée à la longueur standard de la broche et un prolongement 10 du même diamètre que la broche est prévu à la partie inférieure du manchon, prolongement qui sera enfiché dans la carte. La longueur de ce prolongement dépend naturellement de l'épaisseur de la carte.

Conformément à un autre mode de réalisation, au lieu de monter les manchons sur les broches, on peut réaliser directement des broches munies d'ailettes telles que référencée en 6 sur la figure 3. Ce mode de réalisation qui implique une modification des broches standards évite une étape lors de l'assemblage.

Sur la figure 5, on a représenté deux courbes. La courbe A représente la résistance thermique (°C/w) mesurée avec un module équipé du dispositif de refroidissement de la présente invention et la courbe B représente la résistance thermique mesurée avec un module standard, en fonction de la ventilation exprimée en mètre par seconde. On peut voir qu'en l'absence de ventilation (convexion naturelle), la dissipation thermique est améliorée de 10%, cette amélioration devient plus sensible lorsque la ventilation augmente. Lorsqu'elle atteint la valeur de 7m/s, la dissipation thermique est améliorée de 50% environ.

Bien que l'on ait décrit dans ce qui précède et représenté sur les dessins, les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

REVENDICATIONS

1. Dispositif pour le refroidissement d'un module dans lesquels des microplaquettes de circuits intégrés sont disposées sur un substrat muni de broches d'entrée/sortie destinées à être enfichées dans une carte de circuits imprimés, caractérisé en ce qu'il comprend :

une pluralité de manchons, chaque manchon comprenant un corps cylindrique au moins partiellement creux destiné à recevoir une broche du module et des ailettes pour accroître la dissipation thermique des broches.

2. Dispositif selon la revendication 1, caractérisé en ce que le diamètre intérieur du corps creux est au moins égal au diamètre extérieur des broches.

3. Dispositif selon la revendication 1 ou 2 caractérisé en ce que les manchons sont constitués en un même matériau que les broches.

4. Dispositif selon l'une quelconque des revendications précédentes, caractérisé en ce que les ailettes sont en forme d'anneaux et sont régulièrement espacées le long du corps cylindrique creux.

5. Dispositif selon l'une quelconque des revendications précédentes, caractérisé en ce que les manchons sont utilisés comme entretoises entre le module et la carte sur laquelle il est monté.

6. Dispositif selon l'une des revendications 1 à 4 caractérisé en ce que le manchon se termine par une broche.

7. Dispositif pour le refroidissement des modules dans lesquels des microplaquettes de circuits intégrés sont disposés sur un substrat et qui comportent des broches d'entrée/sortie destinées à être enfichées dans des
cartes de circuits imprimés, caractérisé en ce que:

les broches comportent sur leur partie supérieure des
ailettes en forme d'anneaux régulièrement espacées
pour diffuser la chaleur.

0054597

## FIG. 1

## FIG. 2

## FIG. 3

## FIG. 4

# FIG.5

## DOCUMENTS CONSIDERES COMME PERTINENTS

| Catégorie | Citation du document avec indication, en cas de besoin, des parties pertinentes | Revendication concernée |
|---|---|---|
| | <u>DE - B - 1 157 281</u> (F.R.BONHOMME) <br><br> * figure 9; colonne 5, ligne 62 - colonne 6, ligne 3 * <br><br> & FR - E - 74 195 <br><br> -- | 1,2,4 |
| | <u>FR - A - 1 037 060</u> (M.THOUY) <br><br> * figure 1; abrégé * <br><br> -- | 1,4,7 |
| A | <u>US - A - 3 636 501</u> (D.K.WALSH) <br><br> * figure 6; colonne 2, lignes 41-46 * <br><br> ------------- | 1,6 |

**CLASSEMENT DE LA DEMANDE (Int. Cl.³)**

H 01 L 23/48
H 01 L 23/40
H 01 L 23/36
H 01 R 13/533

**DOMAINES TECHNIQUES RECHERCHES (Int. Cl.³)**

H 01 L 23/48
H 01 L 23/40
H 01 L 23/36
H 01 K 13/533

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille. document correspondant

Le présent rapport de recherche a ete etabli pour toutes les revendications

| Lieu de la recherche | Date d'achèvement de la recherche | Examinateur |
|---|---|---|
| | 09-09-1981 | DE RAEVE |

OEB Form 1503.1   06.78